# EUROPÄISCHE PATENTSCHRIFT

(11) **EP 2 255 422 B1**
(45) Veröffentlichungstag und Bekanntmachung des Hinweises auf die Patenterteilung: **20.06.2012**
(21) Anmeldenummer: 09710662.9
(22) Anmeldetag: 16.02.2009
(51) Int. Cl.: H01S 5/04, H01S 5/343, H01S 5/34

(54) **INFRAROT-HALBLEITERLASER**
INFRARED SEMICONDUCTOR LASER
LASER SEMI-CONDUCTEUR INFRAROUGE

(30) Priorität: 15.02.2008 DE 102008009412
(43) Veröffentlichungstag der Anmeldung: 01.12.2010
(73) Patentinhaber: Fraunhofer-Gesellschaft zur Förderung der angewandten Forschung e.V., 80686 München (DE)
(72) Erfinder: SCHULZ, Nicola, 5300 Turgi (CH); RATTUNDE, Marcel, 79194 Gundelfingen (DE); WAGNER, Joachim, 79108 Freiburg (DE); RÖSENER, Benno, Dr., 70176 Stuttgart (DE)
(74) Vertreter: Pfenning, Meinig & Partner GbR
(86) Internationale Anmeldenummer: PCT/EP2009/001066
(87) Internationale Veröffentlichungsnummer: WO 2009/100943

(56) Entgegenhaltungen:
- US-A1- 2003 043 877
- US-A1- 2007 153 856
- US-A1- 2007 274 361
- VAUGHN L G ET AL: "Type I mid-infrared MQW lasers using AlInAsSb barriers and InAsSb wells" PROCEEDINGS OF THE SPIE, SPIE, BELLINGHAM, VA, US, Bd. 5722, Nr. 1, 1. April 2005 (2005-04-01), Seiten 307-318, XP002392478 ISSN: 0277-786X
- GRAY A L ET AL: "High-resolution x-ray and transmission electron microscopic analysis of a GaInAsSb/AlGaAsSb multiple quantum well laser structure" JOURNAL OF APPLIED PHYSICS, AMERICAN INSTITUTE OF PHYSICS. NEW YORK, US, Bd. 85, Nr. 11, 1. Juni 1999 (1999-06-01), Seiten 7664-7670, XP012046393 ISSN: 0021-8979
- SCHULZ NICOLA ET AL: "Resonant optical in-well pumping of an (AlGaIn)(AsSb)-based vertical-external-cavity surface-emitting laser emitting at 2.35 mu m" APPLIED PHYSICS LETTERS, AIP, AMERICAN INSTITUTE OF PHYSICS, MELVILLE, NY, US, Bd. 91, Nr. 9, 28. August 2007 (2007-08-28), Seiten 91113-91113, XP012100837 ISSN: 0003-6951
- NEWELL T ET AL.: "The Effect of Increased Valence Band Offset on the Operation of 2 mu m GaInAsSb-AlGaAsSb Lasers" IEEE PHOTONICS TECHNOLOGY LETTERS, Bd. 11, Nr. 1, 1. Januar 1999 (1999-01-01), Seiten 30-32, XP011046425 ISSN: 1041-1135
- GRAU M ET AL: "Room-temperature operation of 3.26[mu]m GaSb-based type-I lasers with quinternary AlGaInAsSb barriers" APPLIED PHYSICS LETTERS, AIP, AMERICAN INSTITUTE OF PHYSICS, MELVILLE, NY, US, Bd. 87, Nr. 24, 5. Dezember 2005 (2005-12-05), Seiten 241104-1-241104-3, XP012076811 ISSN: 0003-6951
- SOLOV'EV V A ET AL: "MBE growth and photoluminescence properties of strained InAsSb/AlSbAs quantum wells" JOURNAL OF CRYSTAL GROWTH, ELSEVIER, AMSTERDAM, NL, Bd. 251, Nr. 1-4, 1. April 2003 (2003-04-01), Seiten 538-542, XP004416233 ISSN: 0022-0248

## Beschreibung

Die Erfindung betrifft einen Halbleiterlaser mit Typ-I-Laserstruktur, welcher eine verbesserte Effizienz und größere maximale Wellenlängen erreicht.

Im optischen Spektralbereich zwischen 2 und 4 µm (Teilbereich des mittleren Infrarots) befinden sich mehrere atmosphärische Transmissionsfenster sowie Absorptionsbanden von zahlreichen Gasen und chemischen Substanzen. Darüber hinaus besitzt Wasser sein absolutes Absorptionsmaximum bei einer Wellenlänge von 3 µm. Effiziente und kompakte Laserquellen in diesem Wellenlängenbereich sind somit von zentraler Bedeutung für eine Vielzahl von Anwendungen, sowohl in wissenschaftlichen, medizinischen und kommerziellen, als auch in sicherheitsrelevanten und militärischen Bereichen.

Herkömmliche Lasertypen, wie z.B. Thulium-, Holmium- oder Erbium-dotierte Festkörper- oder Faserlaser emittieren zwar in diesem Wellenlängenbereich, jedoch existieren hier nur vereinzelte Emissionslinien oder -banden der verschiedenen Lasermaterialien, die keine vollständige Abdeckung des genannten Spektralbereichs ermöglichen. Somit kann mit diesen Lasertypen eine Anpassung der Emissionswellenlänge an konkrete Anwendungen nur eingeschränkt erfolgen.

Eine Anpassung kann aber durch Verwendung von Halbleiterlasern auf Basis der III/V-Verbindungshalbleiter realisiert werden. Hier können durch Variation der Schichtstrukturen und Materialzusammensetzungen prinzipiell Emissionswellenlängen realisiert werden, die das mittlere Infrarot vollständig abdecken. So existieren im mittleren Infrarot bislang mehrere Typen solcher Halbleiterlaser, wobei hier zwischen elektrisch und optisch gepumpten Lasern unterschieden werden kann.

Beispiele für elektrisch gepumpte Halbleiterlaser im mittleren Infrarot sind Doppelheterostruktur-Diodenlaser, Gasb-basierende "Typ-I"-Laser mit Emissionswellenlängen zwischen 1.8 und 3.3 µm sowie Quantenkaskadenlaser (QCL) mit λ ≥ 3 µm. Optisch gepumpte Laser in diesem Spektralbereich sind z.B. Laser mit "Typ-II"- oder "W"-Laserstruktur (Wellenlänge λ = 2.4 - 9.3 µm.

Jedes dieser Konzepte hat bauartspezifische Vor- und Nachteile. Beispielsweise emittieren QCLs einen stark divergenten Ausgangsstrahl und erreichen insbesondere in dem für diese Erfindung relevanten Wellenlängenbereich (λ ≤ 4 µm) nur geringe Effizienzen, Ausgangsleistungen und maximale Betriebstemperaturen (J. Devenson, R. Teissier, O. Cathabard und A. Baranov, "InAs/AlSb quantum cascade laser emitting below 3 µm", Appl. Phys. Lett. 90, 111118 (2007)). Darüber hinaus können aufgrund grundlegender physikalischer Effekte oberflächenemittierende QCLs nicht realisiert werden. Mit InAs/GaSb-basierenden Lasern mit Typ-II-Laserstruktur werden etwas kürzere Wellenlängen bei höherer Effizienz erreicht [R. Kaspi, A. Ongstad, G. Dente, J. Chavez, M. Tilton und D. Gianardi, "High performance optically pumped antimonide lasers operating in the 2.4-9.3 µm wavelength range", Appl. Phys. Lett. 88, S. 041122 (2006)], allerdings ist hier aufgrund eines räumlich indirekten elektronischen Übergangs zwischen Leitungs- und Valenzband der zur Laseraktivität benötigte optische Gewinn im Vergleich zu Typ-I-Lasern mit räumlich direktem Übergang geringer. Die beiden vorgestellten Lasertypen sind für effizienten Laserbetrieb, insbesondere für den Dauerstrichbetrieb, auf (z.T. kryogene) Kühlung angewiesen, was den Anwendungsbereich stark einschränken kann.

In Halbleiterlasern mit "Typ-I"-Struktur des aktiven Bereichs wird Laserstrahlung erzeugt, indem in den aktiven Quantenfilmen bzw. Quantentöpfen (engl: quantum well, QW) im Valenzband (VB) und typischerweise im Schweren-Loch-Band (HH-Band, engl.: heavy hole band) Elektron-Loch-Paare unter stimulierter Emission eines Laserphotons rekombinieren. Die Elektron-Loch-Paare werden durch Pumpen in den Barriereschichten erzeugt, wandern dann in den Quantenfilm und rekombinieren dort. In GaSb-basierenden Typ-I-Lasern mit Emissionswellenlänge oberhalb von ca. 1.7 µm bestehen die einige Nanometer dicken Quantenfilme in der Regel aus GaₓIn₁₋ₓSb oder GaₓIn₁₋ₓAs_{y}Sb_{1-y}, wobei x und y jeweils den molaren Anteil von Ga (Gallium) bzw. As (Arsen) im Quantenfilm-Material bezeichnen. Die Quantenfilme sind üblicherweise eingebettet in Al_{z}Ga_{1-z}As_{y}Sb_{1-y}-Barrierenschichten, wobei z den molaren Anteil von Al (Aluminium) im quaternären Barrierenmaterial darstellt. Der Arsengehalt y der Barrierenschichten wird typischerweise so eingestellt, dass diese gitterangepasst zum GaSb-Substrat aufgewachsen werden können. Die Gitteranpassung der Barrierenschichten ist jedoch keine zwingende Bedingung zur Herstellung einer Halbleiterlaserstruktur. In der Regel werden Barrierenschichten mit einem molaren Aluminium-Anteil z von ca. 30 bis 35 % verwendet.

Während des Laserbetriebs kann die Temperatur im aktiven Bereich der Laser um einige zehn Grad über der Wärmesenkentemperatur liegen. Hierbei wird die Effizienz von GaSb-basierenden Typ-I-Lasern, insbesondere bei Wellenlängen oberhalb von ca. 2.4 µm, stark herabgesetzt.

Weiterhin entsteht bei Lasern, bei denen mehrere Quantentöpfe hintereinander platziert sind, eine inhomogene Besetzung der Quantentöpfe mit Elektronen, was die Lasereffizienz ebenfalls beeinträchtigen kann.

VAUGHN L G ET AL: "Type I mid-infrared MQW lasers using AllnAsSb barriers and InAsSb wells" PROCEEDINGS OF THE SPIE, SPIE, BELLINGHAM, VA, US, Bd. 5722, Nr. 1, 1. April 2005 (2005-04-01), Seiten 307-318, XP002392478 ISSN: 0277-786X offenbart eine elektrisch gepumpten Laserdiode im MIR.

GRAY A L ET AL: "High-resolution x-ray and transmission electron microscopic analysis of a GalnAsSb/AlGaAsSb multiple quantum well laser structure" JOURNAL OF APPLIED PHYSICS, AMERICAN INSTITUTE OF PHYSICS. NEW YORK, US, Bd. 85, Nr. 11, 1. Juni 1999 (1999-06-01), Seiten 7664-7670, XP012046393 ISSN: 0021-8979 offenbart die Struktur von elektrisch gepumpten MIR Laserdioden.

SCHULZ NICOLA ET AL: "Resonant optical in-well pumping of an (AlGain)(AsSb)-based vertical-external-cavity surface-emitting laser emitting at 2.35 µm" APPLIED PHYSICS LETTERS, AIP, AMERICAN INSTITUTE OF PHYSICS, MELVILLE, NY, US, Bd. 91, Nr. 9, 28. August 2007 (2007-08-28), Seiten 91113-91113, XP012100837 ISSN: 0003-6951 offenbart eine MIR Laserdiode welche optisch gepumpte QW aufweist.

GRAY ET AL: "The Effect of Increased Valence Band Offset on the Operation of 2 µm GalnAsSb-AlGaAsSb Lasers" IEEE PHOTONICS TECHNOLOGY LETTERS, Bd. 11, Nr. 1, 1. Januar 1999 (1999-01-01), Seiten 30-32, XP011046425 ISSN: 1041-1135 offenbart, dass die Löcherlokalisierung bei einer elektrisch gepumpten MIR Laserdiode bis zu einem Al-Anteil von 40% zunimmt.

Es ist daher Aufgabe der Erfindung, einen Halbleiterlaser anzugeben, der bei großen Wellenlängen eine verbesserte Effizienz hat und außerdem die Erzeugung größerer Wellenlängen ermöglicht. Dabei soll der Halbleiterlaser ohne einen höheren Herstellungsäufwand herstellbar sein.

Diese Aufgabe wird gelöst durch den Halbleiterlaser nach Anspruch 1 und das Verfahren zur Erzeugung von Laserstrahlung nach Anspruch 15. Die jeweiligen abhängigen Ansprüche beschreiben vorteilhafte Weiterbildungen des erfindungsgemäßen Halbleiterlasers und des erfindungsgemäßen Verfahrens zur Erzeugung von Laserstrahlung.

Der erfindungsgemäße Halbleiterlaser weist zumindest einen Quantenfilm auf, in welchem Elektron-Loch-Paare rekombinierbar sind. Die Quantenfilme sind zwischen zumindest zwei Barrierenschichten flächig direkt oder über je einen Zwischenfilm angrenzend angeordnet. Diese Barrierenschichten können einerseits Al_{z}Ga_{1-z}As_{y}Sb_{1-y} mit y größer oder gleich Null und kleiner oder gleich Eins und z kleiner oder gleich Eins und größer als 0.4, aufweisen oder daraus bestehen. Alternativ können die Barrierenschichten auch Al_{z}GaᵤInᵥAs_{y}Sb_{1-y} mit z + u + v = 1 und z größer als 0.25 aufweisen oder daraus bestehen. Die ersten drei Elemente sind Elemente der 3. Hauptgruppe, die letzten beiden sind Elemente der 5. Hauptgruppe.

Der erfindungsgemäße Halbleiterlaser weist außerdem eine Pumpvorrichtung auf, mit welcher die Elektron-Loch-Paare unmittelbar im Quantenfilm erzeugbar sind. Durch die Erzeugung der Elektron-Loch-Paare unmittelbar im Quantenfilm hängt der Quantendefekt nicht mehr von der Potentialhöhe der Barrierenschichten ab, so dass diese hinreichend groß gemacht werden kann, um thermische Leckströme von Löchern aus den Quantenfilmen in die umgebenden Barrierenschichten zu verhindern. Auf diese Weise kann die Effizienz des Lasers bei langen Wellenlängen verbessert werden und die maximale Wellenlänge vergrößert werden, wenn die Bandlücke des Quantenfilmes verkleinert wird, und deren energetische Lage gleichzeitig zu niedrigen Energien hin verschoben wird.

Es ist bevorzugt, wenn der oder die Quantenfilme homogen sind, d.h. ihrerseits nicht aus mehreren Schichten aufgebaut sind. Der Quantenfilm kann GaᵢIn₁₋ᵢSb und/oder GaₓIn₁₋ₓASₖSb₁₋ₖ mit i, x und k grö-βer oder gleich Null und kleiner oder gleich Eins aufweisen oder daraus bestehen. Vorzugsweise ist jedoch 0.2 ≤ i ≤ 0.9, besonders bevorzugt 0.4 ≤ i ≤ 0.8, besonders bevorzugt i = 0.8 und/oder 0.3 ≤ x ≤ 0.8, vorzugsweise 0.4 ≤ x ≤ 0.7 und/oder 0 ≤ k ≤ 0.5, vorzugsweise 0.1 ≤ k ≤ 0.3. Für eine Emissionswellenlänge des Lasers von 2.35 µm ist beispielsweise Ga_{0.64}In_{0.36}As_{0.1}Sb_{0.9} besonders geeignet, während für eine Emissionswellenlänge von 3.26 µm Ga_{0.45}In_{0.55}As_{0.31}Sb_{0.69} besonders geeignet ist. Generell gilt hierbei, dass je größer die Wellenlänge ist, desto kleiner der Anteil an Ga ist, während der Anteil an As umso größer ist. Zwar gibt es im betrachteten Wellenlängenbereich hier auch Ausnahmen, grundsätzlich ist das Verhalten jedoch monoton.

Bevorzugt ist generell, dass die Tiefe des Potentialtopfes im Quantenfilm in einem Heavy-Hole-Band so groß ist, dass bei Temperaturen, wie sie im Betrieb des Lasers auftreten, im Wesentlichen kein oder nur ein sehr geringer thermischer Leckstrom aus oder in Schichten auftritt, die an den Quantenfilm grenzen. Die Tiefe dieses Quantentopfes kann durch Wahl des Materials der Barrierenschichten eingestellt werden, ohne dabei einen größeren Quantendefekt zu erzeugen. Auf diese Weise ist die Effizienz des Lasers vor allem im Bereich langer Wellenlängen deutlich steigerbar.

Zur Erzielung des erfindungsgemäßen Effektes werden die Elektronen-Loch-Paare unmittelbar im Quantenfilm erzeugt, während in den Barrierenschichten keine Elektronen-Loch-Paare erzeugt werden. Hierzu , werden durch die Pumpvorrichtung Photonen erzeugt und in den Quantenfilm eingebracht , deren Energie kleiner oder gleich der Bandlückenenergie der Barriereschichten ist, deren Energie aber gleichzeitig größer ist als die Bandlückenenergie des Quantenfilmes. Es ist also vorteilhaft, wenn mit der Pumpvorrichtung so pumpbar ist, dass in den Barriereschichten im Wesentlichen keine Elektronen-Loch-Paare angeregt werden und/oder ausschließlich Sub-Bandgap-Absorption stattfindet. Hierdurch können Energieverluste durch den Quantendefekt vermieden werden.

Für das Material der Barrierenschichten kann z gleich Eins sein, so dass das Material keinerlei Gallium aufweist. In diesem Fall ist das Material der Barrierenschichten also ternäres AlAs_{y}Sb_{1-y}. Insbesondere gegenüber quaternärem Al_{z}Ga_{1-z}As_{y}Sb_{1-y} mit z kleiner als 1 hat dies den Vorteil, dass es einfacher aufgewachsen werden kann und die Zusammensetzung noch präziser hergestellt werden kann. Beide der genannten Materialien sind jedoch in der vorliegenden Erfindung für die Barrierenschichten einsetzbar. Im Falle des quaternären Materials ist z größer 0.4, vorzugsweise größer oder gleich 0.7, besonders bevorzugt größer oder gleich 0.9. Im Falle z gleich 1 liegt wie beschrieben ternäres Material vor.

Die Pumpvorrichtung des erfindungsgemäßen Lasers kann optisch und/oder elektrisch pumpen, so dass die Elektronen-Loch-Paare im Quantenfilm mittels optischen und/oder elektrischen Pumpens erzeugbar sind.

Die erfindungsgemäße Halbleiterlaserstruktur ist besonders zur Erzeugung langwelliger Strahlung geeignet. Der Laser ist daher vorzugsweise so ausgestaltet, dass mit ihm elektromagnetische Strahlung einer Wellenlänge zwischen 1.5 und 5 µm, vorzugsweise zwischen 2 und 4.5 µm, vorzugsweise zwischen 2.5 und 4 µm, vorzugsweise größer oder gleich 3 µm erzeugbar ist.

Wie beschrieben kann zwischen je einem Quantenfilm und einer oder zwei der an diesen grenzenden Barrierenschichten ein Zwischenfilm angeordnet sein. Dieser kann das oben für die Barrierenschichten genannte Material Al_{z}Ga_{1-z}As_{y}Sb_{1-y} aufweisen oder daraus bestehen, wobei jedoch z vorzugsweise kleiner ist als in der Barriereschicht. Auch das genannte GaInAsSb sowie AlGaInAsSb kann für die Zwischenfilme verwendet werden, wobei die Bandlückenergie des Zwischenfilms vorzugsweise größer oder gleich der Bandlückenenergie des Quantenfilms ist. Der Zwischenfilm kann beliebig dünn ausgestaltet sein, so dass seine minimale Dicke eine Atomlage ist. Auf den Zwischenfilm kann aber auch vollständig verzichtet werden.

Vorzugsweise ist die Laserstruktur auf einem Substrat angeordnet, wobei dann das Substrat mit einer der Barrierenschichten in Kontakt sein kann oder durch weitere Strukturen, wie z.B. einen Bragg-Reflektor, von der substratnächsten Barriereschicht separiert sein kann. Das Substrat weist vorzugsweise GaSb, GaAs und/oder InAs auf oder besteht daraus, wobei das Material der Barrierenschichten vorzugsweise so eingestellt ist, dass die an das Substrat grenzende Barriereschicht zu dem Substrat gitterangepasst oder verspannt aufgewachsen ist. In einer weiteren Ausführungsvariante kann das Substrat nach der Herstellung der Laserstruktur auch vollständig entfernt werden.

Der erfindungsgemäße Halbleiterlaser kann eine beliebige Anzahl von Quantenfilmen aufweisen, welche durch Barrierenschichten und eventuell durch Zwischenschichten voneinander getrennt sind. Zu äußerst der Struktur ohne ein eventuelles Substrat können hierbei dann Barrierenschichten liegen. Durch das Erzeugen der Elektronen-Loch-Paare in den Quantenfilmen kann das Problem der inhomogenen Besetzung der Quantentöpfe mit Elektronen aufgrund der großen Tiefe im Valenzband bei einem entsprechenden Design der Laserstruktur, bei dem in jedem Quantentopf durch Pumpabsorption ungefähr die gleiche Anzahl von Ladungsträgern erzeugt wird, ebenfalls umgangen werden.

Erfindungsgemäß ist auch ein Verfahren zur Erzeugung von Laserstrahlung mit einer Wellenlänge größer oder gleich 1,5 µm, vorzugsweise größer oder gleich 2 µm, vorzugsweise größer oder gleich 2,5 µm, vorzugsweise größer oder gleich 3 µm, wobei in einer Halbleiterlaserstruktur Elektronen-Loch-Paare unmittelbar in einem Quantenfilm erzeugt werden. Dieser Quantenfilm ist vorzugsweise zwischen Barrierenschichten angeordnet, in welchen beim Pumpen keine Elektronen-Loch-Paare erzeugt werden. Das erfindungsgemäße Verfahren ist mit dem oben beschriebenen Halbleiterlaser ausführbar.

Vorzugsweise ist eine Potentialtiefe des Quantenfilmes in einem Heavy-Hole-Band so groß, dass bei im Betrieb des Lasers auftretenden Temperaturen im Wesentlichen kein thermischer Leckstrom aus oder in an den Quantenfilm grenzende Schichten auftritt.

Vorzugsweise ist mit der Pumpvorrichtung so pumpbar, dass in den Barriereschichten im Wesentlichen keine Elektron-Loch-Paare angeregt werden und/oder nur Sub-Bandgap-Absorption stattfindet.

Vorzugsweise weist der Zwischenfilm eine Dicke von mindestens einer Atomlage auf.

Vorzugsweise ist der Brechungsindex der Barrierenschichten bei der Wellenlänge der Laseremission kleiner als der Brechungsindex des Quantenfilms.

Durch den erfindungsgemäßen Halbleiter werden die beschriebenen, bei bisherigen GaSb-basierenden Typ-I-Laserstrukturen auftretenden Probleme vollständig gelöst.

Durch die Erfindung können diese Laser im bislang abgedeckten Wellenlängenbereich bis ca. 3 µm in ihrer Effizienz verbessert und bei längeren Wellenlängen überhaupt erst ermöglicht werden, ohne dabei den Herstellungsaufwand grundsätzlich zu erhöhen. Im Vergleich zu den Lasertypen nach dem Stand der Technik sind höhere Effizienzen und Ausgangsleistungen sowie ein reduzierter Kühlbedarf möglich. Abhängig von der Bauart des Lasers (kanten- oder oberflächenemittierend, mit oder ohne externem Resonator) ist Laserbetrieb bei niedriger Divergenz und nahezu beugungsbegrenzter Qualität des emittierten Laserstrahls möglich, was z.B. für optische Freistrahl-Anwendungen von zentraler Bedeutung ist.

**•** Durch das In-Well-Pumpen wird im Vergleich zu elektrisch gepumpten oder optisch Barrieren-gepumpten Lasern die Erzeugung von Verlustwärme reduziert.

**•** Durch die gleichzeitige Verwendung von AlAs_{y}Sb_{1-y}- bzw. Al_{z}Ga_{1-z}As_{y}Sb_{1-y}-Barrierenschichten mit einem Al-Anteil z von mehr als 40 % werden im Vergleich zu herkömmlichen Strukturen thermische Leckströme von Löchern in die umgebenden Barrierenschichten wirkungsvoll unterdrückt.

Darüber hinaus ergeben sich noch weitere, sich auf den Laserbetrieb positiv auswirkende Eigenschaften bei der Verwendung von AlAs_{y}Sb_{1-y}- bzw. Al_{z}Ga_{1-z}As_{y}Sb_{1-y}-Barrierenschichten mit einem Al-Anteil z von mehr als ca. 40 %:

**•** Mit zunehmendem Al-Gehalt der Barrierenschichten nimmt der Brechungsindex n der Barrierenschichten ab. Beispielsweise ist bei einer Wellenlänge von 2.3 µm bei z = 0.3 der Brechungsindex n = 3.6 und bei z = 1 beträgt n = 3.1. Das Quantenfilmmaterial besitzt bei dieser Wellenlänge einen Brechungsindex von ungefähr 4. Besitzen nun die den Quantenfilm umgebenden Barrierenschichten bezüglich des Quantenfilmmaterials einen niedrigeren Brechungsindex, wird die optische Intensität der Lasermode im Bereich der Quantenfilme überhöht. Die Überhöhung ist umso größer, je niedriger der Brechungsindex in den Barrierenschichten ist. Durch den sich hieraus ergebenden höheren Überlapp der optischen Mode mit den Quantentöpfen erhöht sich der modale Gewinn der Quantentöpfe bei einer gegebenen Quantentopf-Ladungsträgerdichte. Somit kann der zum Erreichen der Laserschwelle benötigte modale Gewinn schon bei einer geringeren Ladungsträgerdichte erreicht werden als bei Verwendung von Barrierenschichten mit einem niedrigeren Al-Gehalt und dem daraus resultierenden höheren Brechungsindex. Aufgrund der geringeren Ladungsträgerdichte im Quantentopf ist die Rate der dem Laserbetrieb entgegenwirkenden Auger-Rekombinationsprozesse reduziert, da die Auger-Rekombinationsrate mit der dritten Potenz der Ladungsträgerdichte ansteigt.

**•** Die thermische Leitfähigkeit von Al_{z}Ga_{1-z}As_{y}Sb_{1-y} nimmt für z > 50 % aufgrund der geringer werdenden Unordnung in der Gitterstruktur dieses Materials zu. Insbesondere besitzt das ternäre AlAs_{y}Sb_{1-y} eine höhere thermische Leitfähigkeit als quaternäres Al_{z}Ga_{1-z}As_{y}Sb_{1-y}. Aufgrund dieser Materialeigenschaft kann die während des Laserbetriebs in den Quantenfilmen entstehende Verlustwärme effizienter aus diesen in die umgebenden Barrierenschichten abgeführt werden. Aus diesem weiteren Grund sollte sich die Toleranz eines Lasers dieses Typs gegenüber Erhöhungen der Wärmesenkentemperatur oder der Pumpleistung im Vergleich zu Lasern mit einem konventionellen aktiven Bereich zusätzlich erhöhen.

**•** Die inhomogene Besetzung der Quantentöpfe mit Elektronen aufgrund der großen Tiefe im Valenzband kann durch das In-Well-Pumpen bei einem entsprechenden Design der Laserstruktur, bei dem in jedem Quantentopf durch Pumpabsorption ungefähr die gleiche Anzahl von Ladungsträgern erzeugt wird, ebenfalls umgangen werden.

Im Folgenden soll der erfindungsgemäße Halbleiterlaser anhand von Figuren beispielhaft erläutert werden.

Es zeigt
- Figur 1: das Prinzip des erfindungsgemäßen Halbleiterlasers anhand zweier Bandkantendiagramme und
- Figur 2: die Bandkantenprofile eines Lasers mit einer Emissionswellenlänge von 3 µm nach dem Stand der Technik und nach der Erfindung im Vergleich.

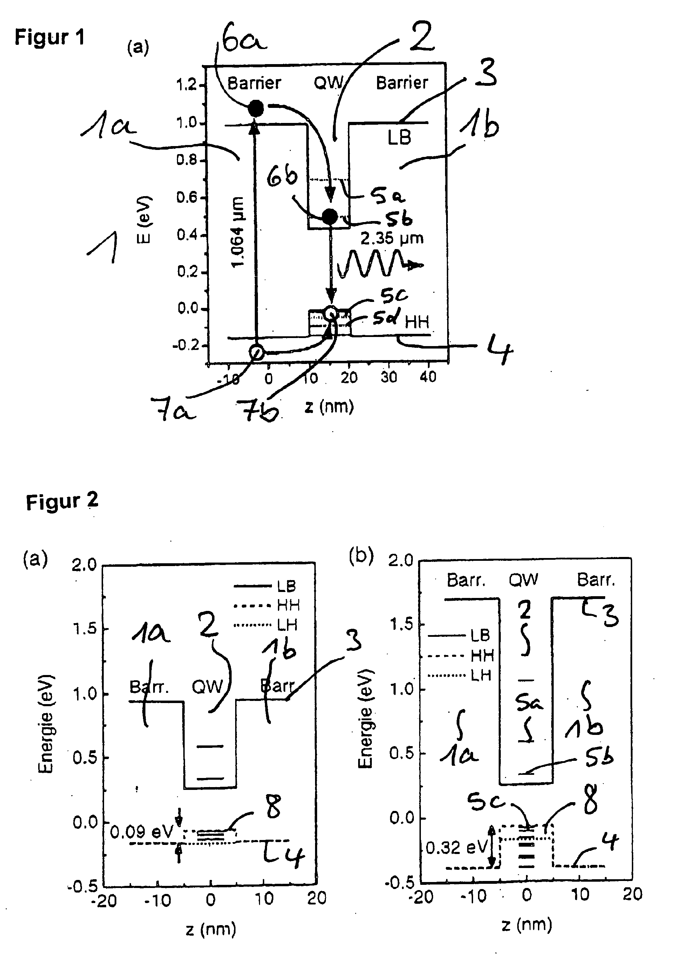

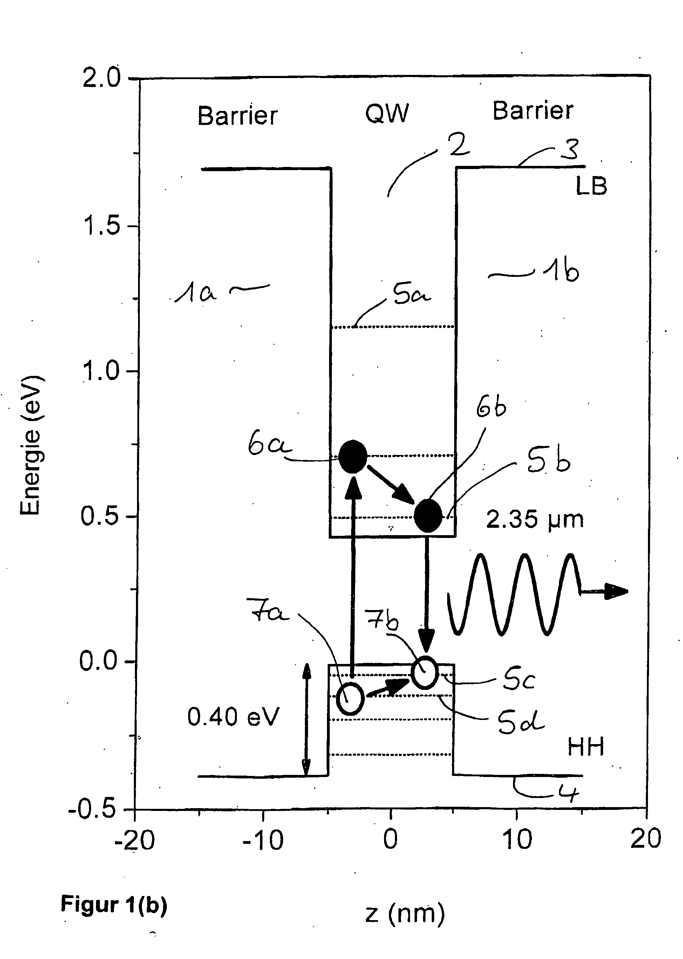

Figur 1 zeigt das Bandkantenprofil eines 10 nm breiten Ga_{0.64}In_{0.36}As_{0.10}Sb_{0.90}-Quantenfilms (Emissionswellenlänge: 2.35 µm). In Teilfigur 1(a) ist dieser entsprechend der Situation im Stand der Technik in Al_{0.30}Ga_{0.70}As_{0.024}Sb_{0.976}-Barrierenschichten eingebettet. In Teilfigur 1(b) ist der Quantenfilm entsprechend der Situation in der vorliegenden Erfindung in Al_{0.90}Ga_{0.10}As_{0.072}Sb_{0.928}-Barrierenschichten eingebettet.

In Figur 1(a) wird die Laserstruktur barrieregepumpt. Hierbei wird durch Einstrahlung elektromagnetischer Strahlung mit einer Wellenlänge von 1.064 µm in der Barrierenschicht 1a ein Elektronen-Loch-Paar 6a, 7a erzeugt. Das Elektronen-Loch-Paar 6a, 7a wandert dann zunächst in den Quantenfilm 2, wo es als Elektronen-Loch-Paar 6b, 7b in den Energieniveaus 5b bzw. 5c des Quantenfilmes 2 liegt. Dieses Elektronen-Loch-Paar 6b, 7b rekombiniert dann unter Aussendung elektromagnetischer Strahlung mit einer Wellenlänge von 2,35 µm. Man erkennt deutlich, dass beim Wandern des Elektronen-Loch-Paares 6a, 7a in den Quantenfilm 2 ein Großteil der Pumpenergie als Quantendefekt in Wärme umgewandelt wird. Während der Potentialtopf im Leitungsband 3 eine große Tiefe hat, ist außerdem der Potentialtopf im Heavy-Hole-Band 4 sehr flach, so dass thermische Leckströme in die Barrierenschichten 1a und 1b fließen können.

Diese Probleme des Standes der Technik werden, wie in Figur 1(b) gezeigt, erfindungsgemäß dadurch behoben, dass nicht in den Barrierenschichten 1a bzw. 1b gepumpt wird, sondern ein Elektronen-Loch-Paar 6a, 7a direkt im Quantenfilm 2 erzeugt wird. Dieses Elektronen-Loch-Paar 6a, 7a begibt sich unter Umwandlung einer kleinen Menge Energie in die Zustände 5b bzw. 5c, wo es dann als Elektronen-Loch-Paar 6b, 7b vorliegt. Von hier rekombiniert es wiederum unter Aussendung elektromagnetischer Strahlung mit einer Wellenlänge von 2.35 µm. Es ist deutlich zu erkennen, dass die Höhe der Barrierenschichten 1a, 1b beliebig verändert werden kann, ohne das Verhalten des Elektronen-Loch-Paares 6a, 7a bzw. 6b, 7b zu beeinflussen. Auf diese Weise können thermische Leckströme in die Barrierenschichten 1a, 1b durch Erhöhung der Barrieren 1a, 1b verhindert werden.

Figur 2 zeigt Bandkantenprofile eines 10 nm breiten Ga_{0.52}In_{0.48}As_{0.22}Sb_{0.78}-Quantenfilms (Emissionswellenlänge: 3.0 µm), eingebettet in Barrierenschichten.

Hierbei zeigt Figur 2(a) die Situation im Stand der Technik, während Figur 2(b) die Situation im erfindungsgemäßen Halbleiterlaser zeigt.

In Figur 2(a) beträgt die Tiefe des Quantentopfes im Heavy-Hole-Band 4 0.09 eV und ist somit zu gering für einen effizienten Laserbetrieb. Durch die geringe Tiefe entsteht ein großer Leckstrom in die Barriereschichten 1a, 1b. Die Barrierenschichten bestehen hier aus Al_{0.30}Ga_{0.70}As_{0.024}Sb_{0.976}.

Erfindungsgemäß kann nun die Bandlückenenergie der Barrierenschicht durch Veränderung des Aluminium- und Galliumanteils im Material der Barrierenschichten beinahe beliebig verändert werden. Dies ist in Figur 2 (b) für Barrierenschichten aus Al_{0.90}Ga_{0.10}As_{0.072}Sb_{0.928} gezeigt. Im Vergleich zu Figur 2(a) ist die Bandlückenenergie der Barrierenschichten 1a, 1b ungefähr doppelt so groß und die Tiefe des Quantentopfes 8 im Heavy-Hole-Band 4 beträgt nun 0.32 eV, was mehr als das Dreifache des Wertes in Figur 2(a) ist. Hierdurch werden thermisch aktivierte Leckströme aus dem Heavy-Hole-Quantenfilm 4 wirksam unterbunden. In den gezeigten Beispielen findet der Laserübergang vom untersten Niveau 5b im Leitungsband zum obersten Niveau 5c im Heavy-Hole-Band 4 statt.

Selbst bei einer Emissionswellenlänge von 4.0 µm, weist der HH-Quantentopf 4 bei Verwendung von Al_{0.90}Ga_{0.10}As_{0.072}Sb_{0.928}-Barrierenschichten eine Tiefe von 0.23 eV auf. Unter Berücksichtigung der epitaktisch herstellbaren Zusammensetzungen des quaternären Quantenfilmmaterials und der sich daraus ergebenden Bandlückenenergien lässt sich somit die maximal erreichbare Emissionswellenlänge von GaSb-basierenden Typ-I-Lasern deutlich steigern.

Es sind auch molare Al-Anteile von bis zu 100 % in den Barrierenschichten 1a, 1b möglich, wodurch der Loch-Einschluss in den HH-Quantentöpfen 8 nochmals erhöht werden kann. Ein Vorteil bei der Verwendung von 100 % Aluminium, d.h. von AlAs_{y}Sb_{1-y} in den Barrierenschichten 1a, 1b ist, dass dieses Material ternär ist und somit einfacher aufgewachsen und die Zusammensetzung noch präziser eingestellt werden kann als quaternäres Al_{z}Ga_{1-z}As_{y}Sb_{1-y}.

## Patentansprüche

1. Halbleiterlaser mit zumindest einem Quantenfilm (2), in welchem Elektron-Loch-Paare rekombinierbar sind,
mit zumindest zwei Barrierenschichten (1a,1b) zwischen denen jeweils einer der zumindest einen Quantenfilme (2), an diese flächig direkt oder über je einen Zwischenfilm angrenzend, angeordnet ist, sowie mit einer optischen Pumpvorrichtung, wobei mit der optischen Pumpvorrichtung die Elektron-Loch-Paare (6a, 7a) unmittelbar im Quantenfilm (2) erzeugt werden, und wobei die Pumpvorrichtung Photonen in den Quantenfilm einbringt, deren Energie kleiner oder gleich der Bandlückenenergie der Barriereschichten (1a, 1b) aber größer als die Bandlückenenergie des Quantenfilmes (2) ist **gekennzeichnet dadurch, dass** die Barriereschichten (1a,1b) Al_{z}Ga_{1-z}As_{y}Sb_{1-y} , mit y größer oder gleich Null und kleiner oder gleich Eins und z kleiner oder gleich Eins und größer als 0.4, aufweisen oder daraus bestehen, und/oder Al_{z}GaᵤInᵥAs_{y}Sb_{1-y} mit z + u + v = 1 und z größer als 0.5 aufweisen oder daraus bestehen.

2. Halbleiterlaser nach dem vorhergehenden Anspruch, **dadurch gekennzeichnet, dass** der Quantenfilm homogen ist und/oder GaᵢIn₁₋ᵢSb und/oder GaₓIn₁₋ₓAsₖSb₁₋ₖ mit i, x und k größer oder gleich Null und kleiner oder gleich Eins aufweist oder daraus besteht.

3. Halbleiterlaser nach dem vorhergehenden Anspruch, **dadurch gekennzeichnet, dass** 0.2 ≤ i ≤ 0.9, vorzugsweise 0.4 ≤ i ≤ 0.8, vorzugsweise i = 0.8 ist und/oder 0.3 ≤ x ≤ 0.8, vorzugsweise 0.4 ≤ x ≤ 0.7 ist, und/oder 0 ≤ k ≤ 0.5, vorzugsweise 0.1 ≤ k ≤ 0.3 ist und/oder dass der Quantenfilm Ga_{0.64}In_{0.36}As_{0.1}Sb₀.₉ für Laser mit einer Emissionswellenlänge von 2.35 µm oder Ga_{0.45}In_{0.55}As_{0.31}Sb_{0.69} für Laser mit einer Emissionswellenlänge von 3.26 µm aufweist oder daraus besteht.

4. Halbleiterlaser nach einem der vorhergehenden Ansprüche, **dadurch gekennzeichnet, dass** zumindest ein Teil der Barriereschichten quaternäres Al_{z}Ga_{1-z}AS_{y}Sb_{1-y} oder ternäres AlAs_{y}Sb_{1-y} aufweisen oder daraus bestehen.

5. Halbleiterlaser nach einem der vorhergehenden Ansprüche, **dadurch gekennzeichnet, dass** z größer oder gleich 0.5, vorzugsweise größer oder gleich 0.7, vorzugsweise größer oder gleich 0.9, vorzugsweise gleich 1 ist.

6. Halbleiterlaser nach einem der vorhergehenden Ansprüche, **gekennzeichnet durch** zwei oder mehr Quantenfilme, welche **durch** Barrierenschichten voneinander separiert sind und zwischen zumindest zwei Barrierenschichten angeordnet sind.

7. Halbleiterlaser nach einem der vorhergehenden Ansprüche, **dadurch gekennzeichnet, dass** der zumindest eine Quantenfilm eine Dicke zwischen 1 nm und 20 nm, vorteilhafterweise zwischen 5 nm und 15 nm hat.

8. Halbleiterlaser nach einem der vorhergehenden Ansprüche, **dadurch gekennzeichnet, dass** die Barriereschichten jeweils eine Dicke größer als 10 nm, vorteilhafterweise größer als 100 nm, vorteilhafterweise von höchstens 20 µm haben.

9. Halbleiterlaser nach einem der vorhergehenden Ansprüche, **dadurch gekennzeichnet, dass** der Brechungsindex der Barriereschichten bei der Wellenlänge der Laseremission kleiner oder gleich 3.6, vorzugsweise kleiner oder gleich 3.4, vorzugsweise kleiner oder gleich 3.1 ist.

10. Halbleiterlaser nach einem der vorhergehenden Ansprüche, **dadurch gekennzeichnet, dass** mit dem Laser elektromagnetische Strahlung einer Wellenlänge größer oder gleich 1.5 µm, vorzugsweise größer oder gleich 2 µm, vorzugsweise größer oder gleich 2.5 µm, vorzugsweise größer der gleich 3 µm erzeugbar ist.

11. Halbleiterlaser nach einem der vorhergehenden Ansprüche, **dadurch gekennzeichnet, dass** mit dem Laser elektromagnetische Strahlung einer Wellenlänge kleiner oder gleich 5 µm, vorzugsweise kleiner oder gleich 4.5 µm, vorzugsweise kleiner oder gleich 4 µm erzeugbar ist.

12. Halbleiterlaser nach einem der vorhergehenden Ansprüche, **dadurch gekennzeichnet, dass** auf einer dem zumindest einen Quantenfilm abgewandten, nicht an einen Quantenfilm grenzenden Seite einer oder zweier der Barrierenschichten zumindest eine Cladding-Schicht angeordnet ist.

13. Halbleiterlaser nach einem der vorhergehenden Ansprüche, **dadurch gekennzeichnet, dass** der Zwischenfilm Al_{z}Ga_{1-z}As_{y}Sb_{1-y} mit z kleiner als in der Barriereschicht, GaInAsSb, AlGaInAsSb, aufweist oder daraus besteht, wobei die Bandlückenenergie des Zwischenfilms größer oder gleich der Bandlückenenergie des Quantenfilms ist.

14. Halbleiterlaser nach einem der vorhergehenden Ansprüche, **gekennzeichnet durch** ein Substrat, auf welchem die Barriereschichten und der zumindest eine Quantenfilm untergebracht sind, wobei das Substrat GaSb, GaAs und/oder InAs aufweist oder daraus besteht, und wobei y so eingestellt ist, dass die an das Substrat grenzende Barriereschicht zu diesem gitterangepasst oder verspannt aufgewachsen ist.

15. Verfahren zur Erzeugung von Laserstrahlung mit einer Wellenlänge größer oder gleich 1.5 µm, vorzugsweise größer oder gleich 2 µm, vorzugsweise größer oder gleich 2.5 µm, vorzugsweise größer oder gleich 3 µm, wobei unmittelbar in einem Quantenfilm (2) einer Halbleiterstruktur Elektron-Loch-Paare (6a, 7a) erzeugt werden und wobei ein Halbleiterlaser nach einem der Ansprüche 1 bis 14 verwendet wird.

## Claims

1. Semiconductor laser having at least one quantum film (2) in which electron hole pairs can be recombined,
having at least two barrier (1a, 1b) layers between which respectively one of the at least one quantum films (2) is disposed adjacently to these, directly in a planar manner or via respectively one intermediate film,
and also having an optical pump device, the electron hole pairs (6a, 7a) being produced directly in the quantum film (2) with the optical pump device, and wherein the pump device introduces photons into the quantum film, the energy of which photons is less than or equal to the band gap energy of the barrier layers (1a, 1b) but greater than the band gap energy of the quantum film (2), **characterized in that**
the barrier layers (1a, 1b) having or consisting of Al_{z}Ga_{1-z}As_{y}Sb_{1-y}, with y greater than or equal to zero and less than or equal to one and z less than or equal to one and greater than 0.4,
and/or having or consisting of Al_{z}GaᵤInᵥAs_{y}Sb_{1-y}, with z + u + v = 1 and z greater than 0.5.

2. Semiconductor laser according to the preceding claim, **characterised in that** the quantum film is homogeneous and/or has or consists of GaᵢIn₁₋ᵢSb and/or GaₓIn_{1- x}AsₖSb₁₋ₖ with i, x and k greater than or equal to zero and less than or equal to one.

3. Semiconductor laser according to the preceding claim, **characterised in that** 0.2 ≤ i ≤ 0.9, preferably 0.4 ≤ i ≤ 0.8, preferably i = 0.8 and/or 0.3 ≤ x ≤ 0.8, preferably 0.4 ≤ x ≤ 0.7 and/or 0 ≤ k ≤ 0.5, preferably 0.1 ≤ k ≤ 0.3 and/or **in that** the quantum film has or consists of Ga_{0.64}In_{0.36}As_{0.1}Sb_{0.9} for lasers with an emission wavelength of 2.35 µm or Ga₀.₄₅In₀.₅₅As₀.₃₁Sb_{0.69} for lasers with an emission wavelength of 3.26 µm.

4. Semiconductor laser according to one of the preceding claims, **characterised in that** at least a part of the barrier layers comprises or consists of quaternary Al_{z}Ga_{1-z}As_{y}Sb_{1-y} or ternary AlAs_{y}Sb_{1-y}.

5. Semiconductor laser according to one of the preceding claims, **characterised in that** z is greater than or equal to 0.5, preferably greater than or equal to 0.7, preferably greater than or equal to 0.9, preferably is equal to 1.

6. Semiconductor laser according to one of the preceding claims, **characterised by** two or more quantum films which are separated from each other by barrier layers and are disposed between at least two barrier layers.

7. Semiconductor laser according to one of the preceding claims, **characterised in that** the at least one quantum film has a thickness between 1 nm and 20 nm, advantageously between 5 nm and 15 nm.

8. Semiconductor laser according to one of the preceding claims, **characterised in that** the barrier layers respectively have a thickness greater than 10 nm, advantageously greater than 100 nm, advantageously of at most 20 µm.

9. Semiconductor laser according to one of the preceding claims, **characterised in that** the refractive index of the barrier layers at the wavelength of the laser emission is less than or equal to 3.6, preferably less than or equal to 3.4, preferably less than or equal to 3.1.

10. Semiconductor laser according to one of the preceding claims, **characterised in that** electromagnetic radiation of a wavelength greater than or equal to 1.5 µm, preferably greater than or equal to 2 µm, preferably greater than or equal to 2.5 µm, preferably greater than or equal to 3 µm, can be produced with the laser.

11. Semiconductor laser according to one of the preceding claims, **characterised in that** electromagnetic radiation of a wavelength less than or equal to 5 µm, preferably less than or equal to 4.5 µm, preferably less than or equal to 4 µm, can be produced with the laser.

12. Semiconductor laser according to one of the preceding claims, **characterised in that** at least one cladding layer is disposed on one side, orientated away from the at least one quantum film and not adjacent to a quantum film, of one or two of the barrier layers.

13. Semiconductor laser according to one of the preceding claims, **characterised in that** the intermediate film comprises or consists of Al_{z}Ga_{1-z}As_{y}Sb_{1-y} with z less than in the barrier layer, GaInAsSb, AlGaInAsSb, the band gap energy of the intermediate film being greater than or equal to the band gap energy of the quantum film.

14. Semiconductor laser according to one of the preceding claims, **characterised by** a substrate on which the barrier layers and the at least one quantum film are accommodated, the substrate comprising or consisting of GaSb, GaAs and/or InAs, and y being adjusted such that the barrier layer adjacent to the substrate is grown lattice-adapted to the latter or distorted.

15. Method for production of laser radiation with a wavelength greater than or equal to 1.5 µm, preferably greater than or equal to 2 µm, preferably greater than or equal to 2.5 µm, preferably greater than or equal to 3 µm, electron hole pairs (6a, 7a) being produced directly in a quantum film (2) of a semiconductor structure, and wherein a semiconductor laser according to one of the claims 1 to 14 is used.

## Revendications

1. Laser à semi-conducteur avec au moins un film quantique (2), dans lequel des paires électron-trou sont recombinables,
avec au moins deux couches barrières (1a, 1b) entre lesquelles respectivement un des au moins un film quantique (2) est agencé contre celles-ci directement sur leur surface ou par-dessus un film intermédiaire jouxtant chaque couche, ainsi qu'avec un dispositif de pompage optique, dans lequel, avec le dispositif de pompage optique, les paires électron-trou (6a, 7a) sont directement produites dans le film quantique (2) et dans lequel le dispositif de pompage introduit des photons dans le film quantique, photons dont l'énergie est inférieure ou égale à l'écart énergétique entre les bandes des couches barrières (1a, 1b), mais supérieure à l'écart énergétique entre les bandes du film quantique (2),
**caractérisé en ce que**
les couches barrières (1a, 1b) comportent du, ou sont constituées de, Al_{z}Ga_{1-z}As_{y}Sb_{1-y}, avec y supérieur ou égal à zéro et inférieur ou égal à un et z inférieur ou égal à un et supérieur à 0,4, et/ou comportent du, ou sont constituées de, Al_{z}GaᵤInᵥAs_{y}Sb_{1-y}, avec z + u + v = 1 et z supérieur à 0,5.

2. Laser à semi-conducteur selon la revendication précédente, **caractérisé en ce que** le film quantique est homogène et/ou comporte du GaᵢIn₁₋ᵢSb et/ou du GaₓIn₁₋ₓASₖSb₁₋ₖ avec i, x et k supérieurs ou égaux à zéro et inférieurs ou égaux à un, ou en est constitué.

3. Laser à semi-conducteur selon la revendication précédente, **caractérisé en ce que** l'on a 0,2 ≤ i ≤ 0,9, de préférence 0,4 ≤ i ≤ 0,8, de préférence i = 0,8, et/ou **en ce que** l'on a 0,3 ≤ x ≤ 0,8, de préférence 0,4 ≤ x ≤ 0,7, et/ou **en ce que** l'on a 0 ≤ k ≤ 0,5, de préférence 0,1 ≤ k ≤ 0,3, et/ou **en ce que** le film quantique comporte du Ga_{0.64}In_{0.36}As_{0.1}Sb_{0.9} pour des lasers avec une longueur d'onde d'émission de 2,35 µm ou du Ga_{0.45}In_{0.55}As_{0.31}Sb_{0.69} pour des lasers avec une longueur d'onde d'émission de 3,26 µm, ou en est constitué.

4. Laser à semi-conducteur selon l'une quelconque des revendications précédentes, **caractérisé en ce qu'**au moins une partie des couches barrières comporte du Al_{z}Ga_{1-z},As_{y}Sb_{1-y} quaternaire ou du AlAs_{y}Sb_{1-y} ou en est constituée.

5. Laser à semi-conducteur selon l'une quelconque des revendications précédentes, **caractérisé en ce que** z est supérieur ou égal à 0,5, de préférence supérieur ou égal à 0,7, de préférence supérieur ou égal à 0,9, de préférence égal à 1.

6. Laser à semi-conducteur selon l'une quelconque des revendications précédentes, **caractérisé par** deux ou plusieurs films quantiques, lesquels sont séparés les uns des autres par des couches barrières et sont disposés entre au moins deux couches barrières.

7. Laser à semi-conducteur selon l'une quelconque des revendications précédentes, **caractérisé en ce que** le au moins un film quantique a une épaisseur comprise entre 1 nm et 20 nm, de manière avantageuse entre 5 nm et 15 nm.

8. Laser à semi-conducteur selon l'une quelconque des revendications précédentes, **caractérisé en ce que** les couches barrières ont chacune une épaisseur supérieure à 10 nm, de préférence supérieure à 100 nm, de manière avantageuse d'au plus 20 µm.

9. Laser à semi-conducteur selon l'une quelconque des revendications précédentes, **caractérisé en ce que** l'indice de réfraction des couches barrières au niveau de la longueur d'onde de l'émission laser est inférieur ou égal à 3,6, de préférence inférieur ou égal à 3,4, de préférence inférieur ou égal à 3,1.

10. Laser à semi-conducteur selon l'une quelconque des revendications précédentes, **caractérisé en ce qu'**avec le laser, on peut produire un rayonnement électromagnétique d'une longueur d'onde supérieure ou égale à 1,5 µm, de préférence supérieure ou égale à 2 µm, de préférence supérieure ou égale à 2,5 µm, de préférence supérieure ou égale à 3 µm.

11. Laser à semi-conducteur selon l'une quelconque des revendications précédentes, **caractérisé en ce qu'**avec le laser, on peut produire un rayonnement électromagnétique d'une longueur d'onde inférieure ou égale à 5 µm, de préférence inférieure ou égale à 4,5 µm, de préférence inférieure ou égale à 4 µm.

12. Laser à semi-conducteur selon l'une quelconque des revendications précédentes, **caractérisé en ce que** sur un côté d'une ou de deux couches barrières, lequel côté étant détourné du au moins un film quantique et ne jouxtant pas un film quantique, est agencée au moins une couche de placage.

13. Laser à semi-conducteur selon l'une quelconque des revendications précédentes, **caractérisé en ce que** le film intermédiaire comporte du Al_{z}Ga_{1-z}As_{y}Sb_{1-y}, avec z plus petit que dans la couche barrière, du GaInAsSb, du AlGaInAsSb ou en est constitué, dans lequel l'écart énergétique entre les bandes du film intermédiaire est supérieur ou égal à l'écart énergétique entre les bandes du film quantique.

14. Laser à semi-conducteur selon l'une quelconque des revendications précédentes, **caractérisé par** un substrat sur lequel sont logés les couches barrières et le au moins un film quantique, dans lequel le substrat comporte du GaSb, du GaAs et/ou du InAs ou en est constitué, et y est ajusté de telle sorte que la couche barrière jouxtant le substrat est adaptée à celui-ci du point de vue du réseau ou y apposé sous contrainte.

15. Procédé de production de rayonnement laser d'une longueur d'onde supérieure ou égale à 1,5 µm, de préférence supérieure ou égale à 2 µm, de préférence supérieure ou égale à 2,5 µm, de préférence supérieure ou égale à 3 µm, dans lequel des paires électron-trou (6a, 7a) sont produites directement dans un film quantique (2) et dans lequel un laser à semi-conducteur selon l'une quelconque des revendications 1 à 14 est utilisé.
